# EUROPÄISCHE PATENTANMELDUNG

(11) **EP 0 725 482 A1**
(43) Veröffentlichungstag der Anmeldung: **07.08.1996**
(21) Anmeldenummer: 96100464.5
(22) Anmeldetag: 13.01.1996
(51) Int. Cl.: H03K 17/975

(54) **Verfahren zur Umsetzung der Position von relativ zueinander bewegten Schalterteilen, Positionsschalter und Verwendung derselben**

(30) Priorität: 06.02.1995 CH 324/95
(71) Anmelder: Electrolux AG, CH-8048 Zürich (CH)
(72) Erfinder: Kunz, Werner, CH-5213 Villnachern (CH)
(74) Vertreter: Troesch Scheidegger Werner AG

(57) **Zusammenfassung**

Es wird ein Schalter vorgeschlagen, bei welchem die Relativposition zweier Teile durch variierende kapazitive Kopplung (15ₐ, 9ₐ, 11ₐ) in einem Wechselspannungs-betriebenen Stromkreis erfasst wird.

## Beschreibung

Die vorliegende Erfindung betrifft ein Verfahren nach dem Oberbegriff von Anspruch 1, einen elektrischen Positionsschalter nach demjenigen von Anspruch 5 sowie Verwendungen des erwähnten Verfahrens bzw. des erwähnten Positionsschalters nach Anspruch 11.

In Stufen schaltbare Drehknopfschalter sind beispielsweise bei Koch- oder Backofensteuerungen hinlänglichst bekannt. Dabei werden in Abhängigkeit der Schalterstellung Steuersignale ausgelöst, welche üblicherweise, am Schluss der Steuerungskette, Leistungsschaltorgane ansteuern.

Auch sind Schieberegler, beispielsweise für Dunstabzughauben, bekannt.

Beide Schalterarten, also Drehstufenschalter wie auch Schieberegler, kontinuierlich steuernd oder in Stufen, weisen grundsätzlich zwei relativ zueinander bewegte Teile auf, deren Relativposition über Potentiometer oder mittels Schleifringen erfasst bzw. umgesetzt werden.

Die positionsabhängige Erzeugung elektrischer Signale über Schleifringe oder mittels Potentiometern ist in verschiedener Hinsicht nachteilig. Verschleisserscheinungen und damit einhergehende Kontaktprobleme begrenzen die Lebensdauer und Zuverlässigkeit derartiger Schaltorgane; gegen Verschmutzung der stromfuhrenden, relativ zueinander bewegten Teile müssen Massnahmen getroffen werden, um die Lebensdauer bzw. Zuverlässigkeit nicht zusätzlich zu verkürzen bzw. zu senken, und es sind relativ viele mechanische Einzelteile für die Realisation derartiger Schaltorgane notwendig.

Die vorliegende Erfindung bezweckt, diese Nachteile zu beheben.

Zu diesem Zweck zeichnet sich das Verfahren eingangs genannter Art nach dem kennzeichnenden Teil von Anspruch 1 aus.

Dadurch, dass grundsätzlich zwischen den relativ zueinander bewegten Teilen eine kapazitive Kopplung erstellt und positionsabhängig verändert wird, ist die Möglichkeit geschaffen, bei derartigen Schaltorganen, ohne dass sich stromführende Leiterpartien berührten, eine Positionsumsetzung vorzunehmen, d.h. positionsabhängige Signale zu erzeugen.

Bevorzugte Ausführungsvarianten des erfindungsgemässen Verfahrens sind in den Ansprüchen 2 bis 4 spezifiziert.

Ein erfindungsgemässer elektrischer Positionsschalter zeichnet sich durch den kennzeichnenden Teil von Anspruch 5 aus, bevorzugte Ausführungsvarianten nach den Ansprüchen 6 bis 10.

Obwohl sich das erfindungsgemässe Vorgehen grundsätzlich für alle Schaltorgane eignet, bei denen, positionsabhängig, Steuersignale ausgelöst werden, eignet sich das erfindungsgemässe Vorgehen insbesondere für Schalter an Schaltkasten für Kochmulden, Backöfen, Geschirrspüler, Dampfabzugsteuerungen, Waschmaschinen, Kaffeemaschinen usw., dabei insbesondere für Küchengeräte, wie Kochherde und Backöfen.

Die Erfindung wird anschliessend beispielsweise anhand von Figuren erläutert.

Es zeigen:
- Fig. 1: ein elektrisches Ersatzschaltbild zur Erläuterung des prinzipiellen erfindungsgemässen Vorgehens;
- Fig. 2: ein elektrisches Ersatzschaltbild zur Erläuterung des erfindungsgemässen Verfahrens bzw. eines entsprechenden Schalters, bei welchem die Schalterposition durch zu- bzw. abnehmende kapazitive Kopplung in elektrische Signale umgesetzt wird;
- Fig. 3: ein Ersatzschaltbild, analog zu demjenigen von Fig. 2, bei welchem die Position durch Zählen oder durch Ableitung von Signalen an positionsspezifischen Leitern umgesetzt wird;
- Fig. 4: schematisch, eine bevorzugte kapazitive Kopplung, bei welcher keine Stromleiter am einen der relativ bewegten Teile vorgesehen sind;
- Fig. 5: ausgehend von den Erläuterungen zu Fig. 4, eine weitere bevorzugte Realisationsform des erfindungsgemässen Vorgehens;
- Fig. 6: in Explosionsdarstellung, eine bevorzugte Ausführungsvariante eines erfindungsgemässen Drehknopfschalters;
- Fig. 7: anhand von Spannungs/Zeitdiagrammen, Signale an einer Anordnung gemäss Fig. 6.

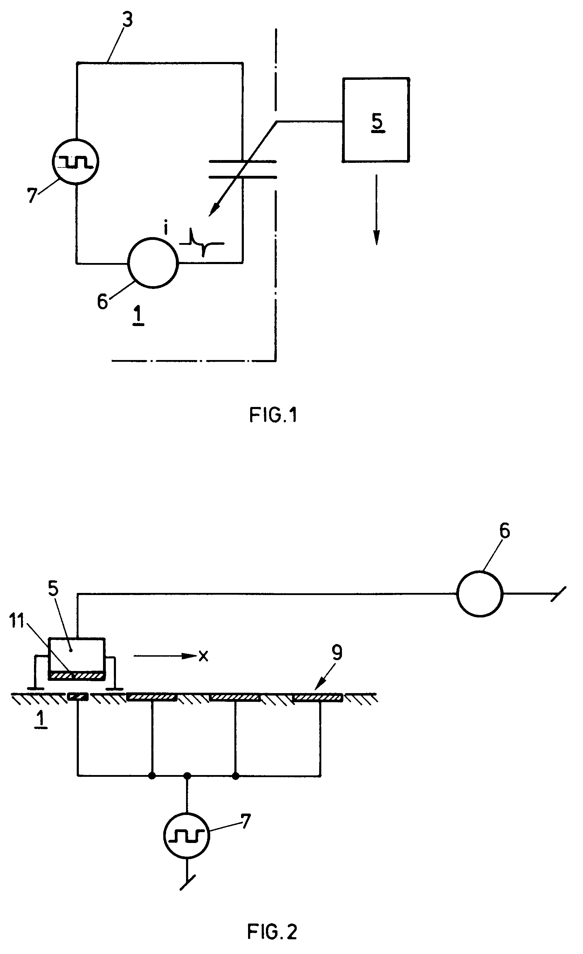

Anhand von Fig. 1 soll das prinzipielle Vorgehen gemäss vorliegender Erfindung erläutert werden.

Ein Stromkreis 3 weist ein kapazitives Element C auf, dessen Kapazitätswert durch Aenderung der Plattengrösse und/oder des Plattenabstandes und/oder des Dielektrikums variierbar ist. Zwei relativ zueinander bewegliche Schalterteile bilden je einen Kapazitätswert-bestimmenden Teil der Kapazität C, so dass der Wert der Kapazität in Abhängigkeit von der Relativposition der Teile, wie mit 1 und 5 in Fig. 1 schematisch dargestellt, variiert. Der Stromkreis 3 wird dabei von einer elektrischen Quelle 7 gespiesen. Grundsätzlich könnte es sich bei der Quelle 7 um eine DC-Signalquelle handeln. Dann ergäbe die Variation der Kapazität C, entsprechend der Relativposition der Teile 1 und 5, einen durchaus messbaren Umladestrom. Aufgrund der jeweils unbestimmten Anfangsladebedingungen an C ist aber eine DC-Speisung eher ungeeignet: Die Quelle 7 ist vorzugsweise eine AC-Quelle, dabei vorzugsweise eine Impulsspannungsquelle.

Wie mit einem Stromdetektor 6 in Fig. 1 schematisch dargestellt, wird der sich aufgrund der variierenden Impedanz mit C ändernde Lade- bzw. Umladestrom i erfasst.

Von diesen prinzipiellen Erläuterungen ausgehend, ist in Fig. 2 das Ersatzbild einer ersten Ausführungsvariante dargestellt, bei der, in Funktion der Relativposition der beiden relativ zueinander bewegten Teile 1 und 5, die kapazitive Kopplung zu- bzw. abnimmt.

Am einen 1 der beiden Teile 1, 5 sind entlang der Relativbewegungsbahn unterschiedlich grosse, elektrisch leitende Flächen 9 angebracht, über welche eine leitende Fläche 11 am Teil 5 bewegt wird. Die jeweilig benachbarten Flächen 9 und 11 bilden die Kapazitätsplatten der Kapazität C gemäss Fig. 1. Der Kapazitätswert variiert mit der Relativposition der Teile, wird in Richtung x im wesentlichen stetig grösser.

Wie beispielsweise dargestellt, werden die leitenden Flächen 9 am Teil 1 durch die Impulsquelle 7 gemeinsam betrieben, während mittels der Strommessanordnung 6 der Strom i von Fläche 11 zurück auf Bezugspotential erfasst wird.

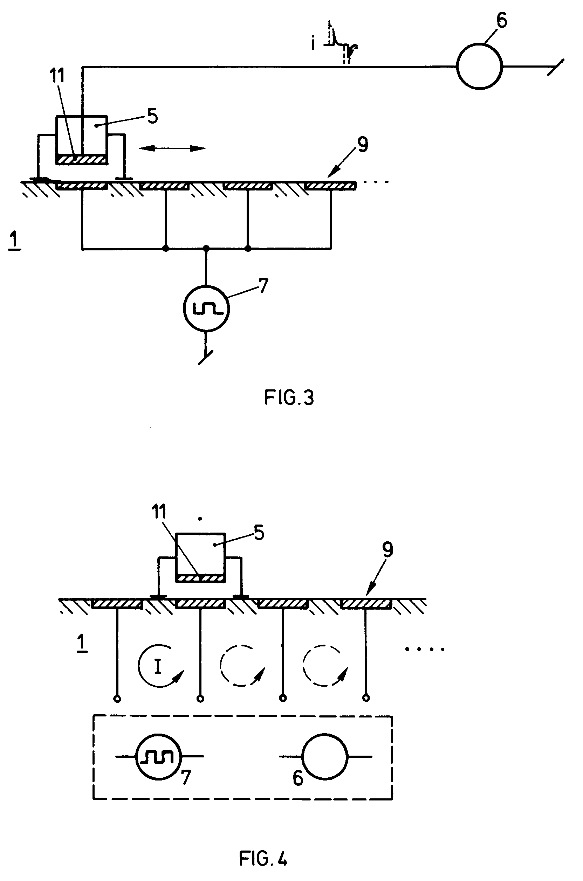

Gemäss einer weiteren Ausführungsvariante, welche in Fig. 3 dargestellt ist, sind die leitenden Flächen 9 gleich gross. Bei Verschieben des Teils 5 werden an der Strommesseinrichtung 6 zyklisch ändernde Stromimpulse registriert. Die eindeutige Identifikation der jeweiligen Position kann dann durch Zykluszählen ab einer Referenzposition erfolgen, oder es kann jeder leitenden Fläche 9 eine Strommesseinrichtung zugeordnet werden und die Quelle 7 in Fig. 3 anstelle des Stromdetektors 6 vorgesehen werden.

Das Vorgehen nach den Fig. 2 bzw. 3 hat weiterhin den Nachteil, dass Stromleiter mitbewegt werden, wie beispielsweise am Teil 5.

Deshalb wird bevorzugterweise die kapazitive Kopplung in der in Fig. 4 dargestellten Art variiert.

Hier wird die leitende Fläche 11 am Teil 5 dazu eingesetzt, die kapazitive Kopplung zwischen benachbarten leitenden Flächen 9 zu variieren. Wie dem Fachmann ohne weiteres ersichtlich, wird dabei ein Stromkreis I zwischen jeweils zwei sich benachbarten Flächen 9 gebildet und sowohl die Quelle 7 wie auch der Detektor 6 an solchen Stromkreisen I eingesetzt.

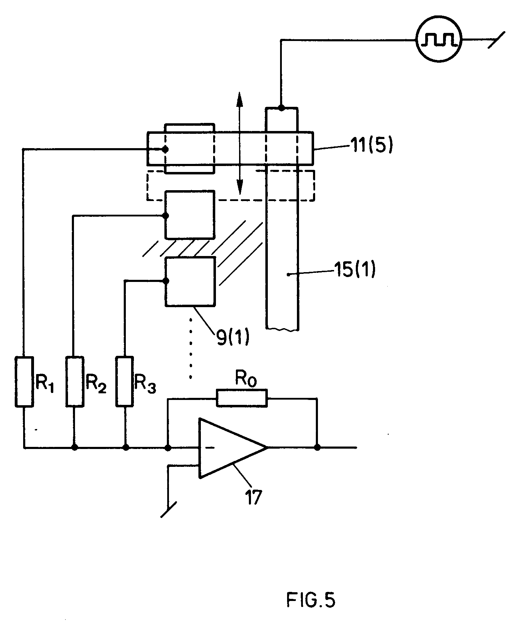

Fig. 5 zeigt schematisch in Aufsicht die bevorzugte Realisationsform des erfindungsgemässen Vorgehens bzw. des erfindungsgemässen Schalters. Hierbei wird mit der Fläche 11 die kapazitive Kopplung zwischen einer entlang der Bewegungsbahn der Teile 1, 5 sich erstreckenden weiteren leitenden Flächen 15 und den positionsidentifizierenden Flächen 9 variiert. Die Flächen 9 und die Fläche 15 sind am selben der relativ zueinander bewegten Teile vorgesehen, so dass auch hier, in Analogie zu Fig. 4, einer der bewegten Teile keine elektrische Zuführungen bzw. Leitungen aufweist.

Gemäss Fig. 5 können dabei bei gleich grossen Flächen 9 die resultierenden Ströme, unterschiedlich gewichtet, R₁, R₂, R₃, auf einen Summationsverstärker 17 geführt werden.

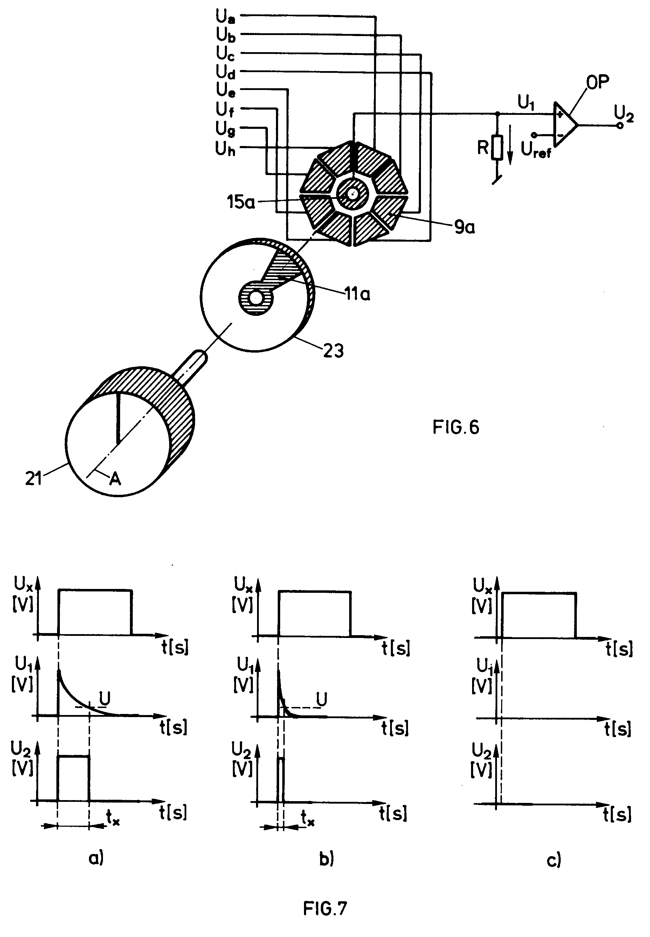

Ausgehend von dem in Fig. 5 dargestellten, bevorzugten Ausführungsprinzip, ist in Fig. 6 eine beispielsweise für Kochherd- oder Backofen-Drehschalter bevorzugte Ausführungsvariante dargestellt.

Um eine Drehknopfachse A sind, geräteseitig, eine Anzahl gleiche Leiterflachen 9ₐ gruppiert, jede mit vorzugsweise unterschiedlichen Impulsquellen, entsprechend Uₐ bis Uₕ verbunden. Zentral ist eine weitere kreisförmige leitende Fläche 15ₐ geräteseitig vorgesehen und, bezüglich der Flächen 9ₐ isoliert, mit dem Eingang eines Stromverstärkers verbunden. Ueber dem Widerstand R wird mit dem Operationsverstärker OP die stromproportionale Spannung abgegriffen. Der Operationsverstärker OP wirkt dabei als Komparator und gibt ein Ausgangssignal U₂ dann ab, wenn die Eingangsspannung U₁ an R über einem vorgebbaren Wert U_{ref} liegt.

Mit dem Drehknopf 21 starr verbunden, ist eine Kopplungsscheibe 23 aus dielektrischem Material vorgesehen, welche auf der den geräteseitigen Flächen 9ₐ, 15ₐ abgewandten Seite eine kreissegmentförmige leitende Fläche 11ₐ aufweist, welche, im Zentrumsbereich, kreisringförmig entsprechend der Formung der Fläche 15ₐ ausgebildet ist. Die Scheibe 23 bzw. ihr Material wirkt dabei als Dielektrikum zwischen den Kapazitätsplatten bildenden Flächen 9ₐ, 15ₐ und 11ₐ. Die Analogie zur Struktur von Fig. 5 ist ohne weiteres ersichtlich.

In Fig. 7 sind drei Verläufe, einerseits, Uₓ, einer an eine der Flächen 9ₐ angelegten Impulsspannung dargestellt, der resultierenden Spannungen U₁ am Widerstand R des Operationsverstärkers OP von Fig. 6 und der aufgrund seiner Komparatorwirkung ausgangsseitig dieses Verstärkers OP erscheinenden Spannung U₂.

Dabei zeigt Fig. 7a die Verläufe, wenn das Flächensegment 11ₐ, drehknopfseitig von Fig. 6, vollständig über einer leitenden Fläche 9ₐ, geräteseitig, liegt. Fig. 7b zeigt die entsprechenden Verläufe, wenn das Flächensegment 11ₐ eine betrachtete Fläche 9ₐ nur teilweise bedeckt, und Fig. 7c die Verläufe, wenn eine Fläche 9ₐ vom Segment 11ₐ nicht bedeckt ist.

Aus Betrachtung insbesondere von Fig. 7 ist ersichtlich, dass vorzugsweise die Quellen zur Erzeugung der Spannungen Uₐ bis Uₕ phasenverschobene Impulszüge abgeben und Identifizierung, von welcher Fläche 9ₐ ein Ausgangssignal U₂ abgeleitet ist, dadurch erfolgt, dass die Phasenlage der Signale U₂ bezüglich der die Flächen 9ₐ treibenden Impulszüge detektiert wird.

Durch Vorgabe des Komparatorschwellwertes U_{ref} wird, wie in Fig. 7 dargestellt, die sich mit ändernder kapazitiver Kopplung ändernde Impulszeitkonstante des durch U₁ erfassten Lade- bzw. Entladestromverlaufes in eine Impulslänge gemäss U₂ gewandelt. Dabei erscheint, praktisch verzögerungsfrei, die aufsteigende Flanke des Impulses U₂ synchron mit der entsprechenden Flanke des eine der leitenden Flächen 9ₐ treibenden Impulsspannungssignals.

Mit dem dargestellten Vorgehen wird die verschleissfreie Erfassung von Schalterpositionen möglich. Die Schalter werden staub- und schmutzunempfindlich und können ausserordentlich kostengünstig realisiert werden, indem beispielsweise die leitenden Flächen 9ₐ direkt auf eine Printplatine aufgebracht werden, die auch zur Aufnahme weiterer elektronischer Komponenten, wie des Operators OP von Fig. 6, vorzusehen ist.

Der Platzbedarf für einen derartigen Schalter ist, was die schaltwirksamen Teile anbelangt, äusserst gering; es bestehen keine mechanischen Kontaktprobleme, womit, zusammengefasst, kostengünstig und platzsparend, hohe Schaltzuverlässigkeit erzielt wird. Wie erwähnt wurde, lässt sich das dargestellte Prinzip leicht in elektronische Steuerungen integrieren. Selbstverständlich können sowohl Drehschalter wie auch lineare Schiebeschalter, wie beispielsweise in Fig. 5 dargestellt wurde, nach dem erfindungsgemässen Prinzip realisiert werden.

## Patentansprüche

1. Verfahren zur Umsetzung der Position von relativ zueinander bewegten Teilen eines Schaltorganes in mindestens ein davon abhängiges elektrisches Signal, dadurch gekennzeichnet, dass man zwischen den relativ zueinander bewegten Teilen eine kapazitive Kopplung erstellt, welche mit der Relativposition variiert.

2. Verfahren nach Anspruch 1, dadurch gekennzeichnet, dass man über die kapazitive Kopplung ein Wechselstromsignal treibt, vorzugsweise eine Impulsspannung über der Kopplung anlegt, und den Ladestrom erfasst.

3. Verfahren nach einem der Ansprüche 1 oder 2, dadurch gekennzeichnet, dass man die kapazitive Kopplung in Funktion der Position zyklisch oder positionsabhängig zu- bzw. abnehmend variiert.

4. Verfahren nach einem der Ansprüche 1 bis 3, dadurch gekennzeichnet, dass man die kapazitive Kopplung vom einen der Teile zum anderen und zurück zum einen variiert.

5. Elektrischer Positionsschalter mit zwei relativ zueinander bewegten Teilen, dadurch gekennzeichnet, dass am einen, an vorgegebenen Positionen entlang der gegenseitigen Bewegungsbahn, voneinander isolierte, erste leitende Flächen vorgesehen sind, am anderen mindestens eine zweite elektrisch leitende Fläche, deren Bewegungsbahn über die ersten Flächen führt, und dass die ersten Flächen einerseits und die zweite anderseits relativ zueinander bewegte Kondensatorplatten bilden, in einem gespiesenen Stromkreis, woran ein vom Ladungsfluss abhängiges Signal erfasst wird.

6. Positionsschalter nach Anspruch 5, dadurch gekennzeichnet, dass der Stromkreis mindestens eine Wechselspannungsquelle, vorzugsweise mindestens eine Impulsquelle, umfasst.

7. Positionsschalter nach einem der Ansprüche 5 oder 6, dadurch gekennzeichnet, dass der Stromkreis, abgesehen von den leitenden Flächen, galvanische Stromleiter nur am einen der beiden Teile umfasst, die durch die kapazitive Kopplung über den anderen Teil kapazitiv verbunden sind.

8. Positionsschalter nach Anspruch 7, dadurch gekennzeichnet, dass entlang der Relativbewegungsbahn und der ersten (9) leitenden Flächen mindestens eine weitere (15) vorgesehen ist und die Bewegungsbahn der zweiten elektrisch leitenden Fläche (11) sowohl über die ersten (9) wie auch entlang der weiteren (15) leitenden Fläche führt.

9. Positionsschalter nach Anspruch 7, dadurch gekennzeichnet, dass jede erste leitende Fläche (9) mit einer elektrischen Leitung verbunden ist, ebenso die weitere (15), und dass entweder jede Leitung zu den ersten leitenden Flächen (9) mit einer Signalquelle verbunden ist und die Leitung zur weiteren leitenden Fläche (15) auf eine Strommessanordnung (6, 17) gefuhrt ist oder die Leitung zur weiteren leitenden Fläche (15) mit einer elektrischen Signalquelle verbunden ist und die Leitungen zu den ersten leitenden Flächen (9) je oder gemeinsam auf eine Strommesseinrichtung (6, 17) gefuhrt sind.

10. Positionsschalter nach einem der Ansprüche 5 bis 9, dadurch gekennzeichnet, dass die Teile relativ zueinander bewegte Teile eines Drehschalters sind.

11. Verwendung des Verfahrens nach einem der Ansprüche 1 bis 4 oder des Schalters nach einem der Ansprüche 5 bis 10 für Küchengeräte-, wie für Kochherd- oder Backofensteuerungen.
